# NEUE EUROPÄISCHE PATENTSCHRIFT

(11) **EP 3 127 223 B2**
(45) Veröffentlichungstag und Bekanntmachung des Hinweises auf die Entscheidung über den Einspruch: **14.07.2021**
(45) Hinweis auf die Patenterteilung: 18.07.2018
(21) Anmeldenummer: 15712318.3
(22) Anmeldetag: 19.03.2015
(51) Int. Cl.: H02K 5/15, H02K 11/33, H02K 5/20, H02K 11/04

(54) **ELEKTRISCHE MASCHINE**
ELECTRIC MACHINE
MOTEUR ÉLECTRIQUE

(30) Priorität: 31.03.2014 DE 102014205930
(43) Veröffentlichungstag der Anmeldung: 08.02.2017
(73) Patentinhaber: Vitesco Technologies GmbH, 30165 Hannover (DE)
(72) Erfinder: LUDWIG, Detlef, 91227 Diepersdorf (DE); ROGGE, Sebastian, 01445 Radebeul (DE); SCHIRMER, Edmund, 90409 Nürnberg (DE)
(74) Vertreter: Roos, Peter
(86) Internationale Anmeldenummer: PCT/EP2015/055764
(87) Internationale Veröffentlichungsnummer: WO 2015/150087

(56) Entgegenhaltungen:
- EP-A1- 1 418 660
- US-A1- 2007 273 220
- US-A1- 2012 104 884

## Beschreibung

Es ist bekannt, elektrische Maschinen mittels eines geführten Wärmemediums zu kühlen, um insbesondere bei Leistungsanwendungen Verlustwärme effektiv abführen zu können. Da jedoch mehrere Komponenten innerhalb des Elektromotors Verlustwärme erzeugen können und somit nicht nur der Stator zu kühlen ist, erfordert die Führung des Wärmemediums einen hohen baulichen Aufwand. Ein Beispiel einer derartigen Konfiguration einer Leistungselektronik für eine elektrische Maschine ist in der US2007/0273220A1 beschrieben. Die Aufgabe der Erfindung ist eine Möglichkeit aufzuzeigen, mit der Verlustwärme aus einer elektrischen Maschine auf einfache Weise sich entfernen lässt.

### Offenbarung der Erfindung

Diese Aufgabe wird gelöst durch die elektrische Maschine nach Anspruch 1. Bevorzugte Ausführungsformen ergeben sich mit den Merkmalen der Unteransprüche sowie mit den Merkmalen, wie sie in der folgenden Beschreibung aufgeführt sind.
Es wurde erkannt, dass sich ein Kühlkanal besonders einfach darstellen lässt, wenn ein Kühlkanal einen Längsabschnitt und einen Stirnseitenabschnitt aufweist, wobei sich der Längsabschnitt entlang des Stators erstreckt und der daran angeschlossener Stirnseitenabschnitt des Kühlkanals entlang einer Fläche geführt wird, durch die sich hindurch die Rotationsachse der elektrischen Maschine erstreckt. Der Längsabschnitt und somit die Strömung des Wärmemediums dort verläuft in axialer Richtung, während der Stirnseitenabschnitt und somit die Strömung des Wärmemediums dort in radialer Richtung oder zumindest in einer Richtung senkrecht zur axialen Richtung verläuft. Die axiale Richtung entspricht der Längserstreckungsrichtung der (Welle der) elektrischen Maschine. Die Strömung in dem Stirnseitenabschnitt wird von diesem entlang von Sekanten geführt, die durch den Stirnseitenabschnitt hindurch verlaufen.
Der Stirnseitenabschnitt führt das Wärmemedium im Wesentlichen senkrecht zu der Richtung, entlang der das Wärmemedium im Längsabschnitt geführt wird, wodurch nicht nur die Umfangfläche des Stators, sondern auch Komponenten an der Stirnseite des Stators (etwa der Wickelkopf und/oder Leistungselektronik) gekühlt werden können. Der Stirnseitenabschnitt ermöglicht eine Kühlung zu beiden Seiten des Stirnseitenabschnitts, dass heißt auf der Seite des Stators zur Kühlung des Wickelkopfs und auf der entgegengesetzten Seite des Stirnseitenabschnitts (in Richtung der Rotationsachse der elektrischen Maschine), an der sich Leistungselektronik bzw. ein Lagerschild befinden kann.

Auf diese Weise wird gleichermaßen eine kompakte Bauweise als auch eine einfache Führung des Wärmemediums ermöglicht. Indem sich der Kühlkanal in einen Längsabschnitt und einen hierzu abgewinkelten Stirnseitenabschnitt aufteilen lässt, können unterschiedlich ausgerichtete Flächen (beispielsweise die Umfangsfläche des Stators und der stirnseitige Wickelkopf bzw. die stirnseitige Leistungselektronik) und somit auch unterschiedliche Komponenten mit dem gleichen Kühlkanal gekühlt werden. Da hierbei der Längsabschnitt unmittelbar in den Stirnseitenabschnitt übergehen kann, wobei der Längsabschnitt und der Stirnseitenabschnitt die äußere Grundform der elektrischen Maschine (abgesehen von einer entgegengesetzten Stirnseite) nachbilden, ist die Ausgestaltung des Kühlkanals besonders einfach und erfordert insbesondere keine zusätzlichen fluidtechnischen Maßnahmen, etwa Verteiler oder ähnliches.

Als Längsabschnitt wird der Abschnitt des Kühlkanals bezeichnet, der sich längs (der Außenseite) der elektrischen Maschine erstreckt, dass heißt in Richtung der Rotationsachse beziehungsweise in Richtung der Welle der elektrischen Maschine. Der Stirnseitenabschnitt, der auch als Querabschnitt bezeichnet werden kann, erstreckt sich bezogen auf die Rotationsachse beziehungsweise die Welle im Wesentlichen radial bzw. entlang von Sekanten durch die Stirnseite hindurch. Dadurch bilden Stirnseitenabschnitt und Längsabschnitt die Begrenzung für einen Raum, in dem sich Komponenten der elektrischen Maschine (Stator, Rotor und auch Wickelkopf) befinden können, wobei insbesondere beide Seiten des Stirnseitenabschnitts (in Richtung der Rotationsachse beziehungsweise der Welle gesehen) verwendet werden, um dort Komponenten anzubringen, deren Verlustwärme abzuführen ist (d.h. die Verlustwärme des Wickelkopfs und der Leistungselektronik). Da sich die Leistungselektronik parallel zu der Ebene erstreckt, entlang der sich der Wickelkopf erstreckt (und die senkrecht zur Welle ist), können auf einfache Weise elektrische Verbindungen zwischen der Leistungselektronik und dem Wickelkopf beziehungsweise den Statorwicklungen hergestellt werden.

Es wird eine elektrische Maschine beschrieben, die mit einem Gehäuse, einem Stator und einem Rotor ausgestattet ist. Der Stator umgreift den Rotor. Die elektrische Maschine ist mit anderen Worten ein Innenläufer. Es sind jedoch auch Ausführungen als Außenläufer möglich, wobei der Rotor hinsichtlich des Aufbaus an die Stelle des Stators tritt und umgekehrt. Der Rotor weist eine Welle auf. Durch diese hindurch erstreckt sich die Rotationsachse der elektrischen Maschine. Die Rotationsachse entspricht der Längsachse der elektrischen Maschine oder ist parallel zu dieser.

Die elektrische Maschine ist ferner mit einer Leistungselektronik ausgestattet. Diese ist innerhalb des Gehäuses angeordnet. Die Leistungselektronik umfasst insbesondere zumindest eine (ein- oder mehrphasige) Leistungsansteuerstufe, die den Stator und ggf. auch den Rotor mit Strom versorgt. Die Leistungsendstufe umfasst Leistungshalbleiter, etwa Leistungstransistoren wie IGBTs oder MOSFETs und/oder Leistungsdioden. Die Leistungsendstufe kann ferner weitere Leistungsbauelemente aufweisen, etwa Leistungskondenstatoren, Leistungswiderstände und/oder Leistungsinduktivitäten. Die Leistungsendstufe ist ferner mit einem Kühlkörper ausgestattet, der insbesondere eine Kühlfläche aufweist, die an den im Weiteren beschriebenen Kühlkanal (insbesondere an den Stirnseitenabschnitt hiervon) angrenzt oder zumindest wärmeübertragend hiermit verbunden ist. Zumindest ein Abschnitt einer Oberfläche der Leistungselektronik oder auch die gesamte Oberfläche der Leistungselektronik grenzt an den Stirnseitenabschnitt an oder ist Wärme leitend mit dieser verbunden. Der Kühlkörper und/oder die Leistungselektronik sind gegenüber dem Kühlkanal elektrisch isoliert, etwa mittels einer Isolationsschicht, die sich entlang der Kühlfläche der Leistungselektronik erstreckt, und/oder mittels Isolationselementen an den Leistungshalbleitern.

Die elektrische Maschine weist einen Kühlkanal auf. Dieser befindet sich innerhalb des Gehäuses. Der Kühlkanal erstreckt sich entlang eines Längsabschnitts und entlang eines Stirnseitenabschnitts. Der Längsverlauf des Kühlkanals umfasst daher eine Einteilung in zumindest einen Längsabschnitt und zumindest einen Stirnseitenabschnitts. Der Längsabschnitt führt entlang der Umfangsfläche des Stators. Der Stirnseitenabschnitt führt entlang einer Stirnseite des Stators bzw. der elektrischen Maschine (jedoch innerhalb des Gehäuses). Der Stirnseitenabschnitt führt insbesondere entlang eines Lagerschilds. Der Stirnseitenabschnitt führt ferner insbesondere entlang einer Innenseite (d.h. zum Stator weisenden Seite) des Stators, etwa entlang eines Wickelkopfs des Stators.

Der Längsabschnitt erstreckt sich entlang eines Hohlzylinders bzw. ist in der Form eines Hohlzylinders ausgeführt oder weist eine umhüllende Fläche auf, die die Form eines Hohlzylinders hat. Der Hohlzylinder ist insbesondere ein Kreiszylinder, kann jedoch auch eine andere Querschnittsform aufweisen (oval, ellipsoid, polygonal, polygonal mit abgerundeten Ecken,...). Durch das Innere des Hohlzylinders ist die Welle geführt. Die Längsachse der elektrischen Maschine bzw. die Rotationsachse kann sich somit durch das Innere des Hohlzylinders erstrecken, und entspricht insbesondere der Längsachse des Hohlzylinders. Der Kreiszylinder und der Rotor (oder auch der Stator) sind zueinander konzentrisch angeordnet.

Der Stirnseitenabschnitt erstreckt sich zur Welle hin. Die Welle bzw. die Längsachse der elektrischen Maschine (d.h. die Rotationsachse) erstreckt sich durch eine Ebene, in deren Richtung sich der Stirnseitenabschnitt erstreckt. Die Welle bzw. die Längsachse der elektrischen Maschine steht insbesondere im Wesentlichen senkrecht zu der Ebene. Der Stirnseitenabschnitt kann die Form eines Rings aufweisen, durch dessen inneres freies Gebiet sich die Welle bzw. die Längsachse hindurch erstreckt. Der Ring kann im Wesentlichen kreisförmig bzw. kreiszylindrisch sein, insbesondere an der zur Welle weisenden Fläche, wobei die Kreisform auch durchbrochen sein kann durch Ausnehmungen oder Ausstülpungen.

Die Höhe des Stirnseitenabschnitt (in Längsachsenrichtung der elektrischen Maschine gesehen) kann konstant sind, ist jedoch vorzugsweise variabel, insbesondere wenn der Wickelkopf und/oder die Leistungselektronik mit einer Fläche an den Stirnseitenabschnitt angrenzen, die nicht eben ist. In der Höhe ist der Stirnseitenabschnitt durch den Stator bzw. durch dessen Wickelkopf einerseits und durch die Leistungselektronik bzw. den Lagerschild begrenzt. Der Stirnseitenabschnitt kann sich bis zur Welle oder in deren Richtung erstrecken. Der Stirnseitenabschnitt ist derart angeschlossen, dass durchströmendes Wärmemedium (d.h. ein Kühlmedium wie Gas oder Flüssigkeit, etwa Luft, Öl oder Wasser) in Richtung Welle geführt wird. Der Längsabschnitt ist derart angeschlossen, dass durchströmendes Wärmemedium entlang der Umfangsfläche des Stators geführt wird. Die Strömungsrichtung im Längsabschnitt führt entlang einer Mantelfläche eines Zylinders, während im Stirnseitenabschnitt die Strömungsrichtung entlang einer Stirnseite des Zylinders führt. Dieser Zylinder und der Hohlzylinder können ein gerader Zylinder oder ein schräg abgeschnittener Zylinder sein.

Der Längsabschnitt kann begrenzt sein durch eine Umfangsfläche des Stators einerseits und durch eine Wand des Gehäuses andererseits. Die Wand des Gehäuses kann eine einfache Wand oder eine Doppel- oder Mehrfachwand sein. Die Innenseite dieser Wand bildet (umfänglich) die Außenseite des Längsabschnitts. Die Außenseite des Stators (oder eines Wicklungskörpers, der den Stator umfasst) bildet (umfänglich) die Außenseite des Längsabschnitts. An einer Stirnseite des Längsabschnitts ist dieser mit dem Stirnseitenabschnitt verbunden, insbesondere mit einer (statorseitigen) Fläche des Stirnseitenabschnitts, die sich in Richtung der Welle erstreckt. Diese Fläche kann der im Weiteren genannten Stirnseite des Stators bzw. einer nach außen weisenden Fortsetzung der Stirnseite des Stators entsprechen.

Der Stirnseitenabschnitt ist begrenzt durch eine Stirnseite des Stators einerseits und der Leistungselektronik andererseits. Der Stirnseitenabschnitt ist an der Seite des Stators begrenzt durch einen Wicklungskopf (bzw. einer an den Wicklungskopf angrenzenden elektrischen Isolationsschicht) des Stators. Ferner kann der Stirnseitenabschnitt wie bereits erwähnt an eine zum Stator weisende Kühlfläche (etwa eines Kühlkörpers) der Leistungselektronik angrenzen. Die Leistungselektronik bzw. deren Kühlfläche und der Stator bzw. dessen Wicklungskopf stehen sich gegenüber. Der Stirnseitenabschnitt ist in der so vorgesehenen Lücke zwischen Stator und Leistungselektronik vorgesehen. Die Lücke zwischen Stator und Leistungselektronik erstreckt sich in einer Richtung, die der Richtung der Längsachse bzw. der Längserstreckungsrichtung der Welle bzw. der Richtung der Rotationsachse entspricht. Der Stirnseitenabschnitt ist angeschlossen, um Wärmemedium senkrecht zu der Richtung dieser Lücke zu leiten. Im Gegensatz hierzu ist der Längsabschnitt angeschlossen, um Wärmemedium entlang dieser Richtung (oder entlang einer Umfangsfläche bzw. Mantel des Stators) zu leiten.

Die Leistungselektronik erstreckt sich entlang einer Ringfläche, durch deren (freie) Mitte hindurch die Welle stößt. Diese Ringfläche kann einer Kreisringfläche entsprechen oder kann eine andere Grundform aufweisen, etwa oval, ellipsoid, polygonal, oder polygonal mit abgerundeten Ecken. Insbesondere kann die Leistungselektronik in mehrere Segmente aufgeteilt sein, die sich jeweils nur über einen Kreissektor oder einen Ringsektor an einer Stirnseite der elektrischen Maschine erstrecken. Die Segmente sind umfänglich an dieser Stirnseite verteilt. Die Leistungselektronik weist vorzugsweise eine Kühlfläche auf, die den Stirnseitenabschnitt (in einer vom Stator weg weisenden Richtung) begrenzt.

Der Längsabschnitt geht unmittelbar in den Stirnseitenabschnitt über. An dem so geschaffenen Übergang können Verbindungselemente angeordnet sein, die eine direkte Fluidverbindung zwischen den beiden Abschnitten des Kühlkanals schaffen, etwa eine sich in zur Welle (bzw. zur Rotationsachse) hin erstreckende Wand mit einer Öffnung, welche die beiden Abschnitte verbindet. Der Querschnitt des Längsabschnitts erstreckt sich zwischen dem Stator und dem Gehäuse. Dieser Querschnitt entspricht somit dem des Hohlzylinders oder entspricht dem Querschnitt einer Einhüllenden, die den Hohlzylinder umgibt. Der Querschnitt des Stirnseitenabschnitts erstreckt sich zwischen dem Stator und der Leistungselektronik und somit in Richtung der Welle bzw. der vorangehend genannten Lücke. Als Querschnitt wird insbesondere die Fläche angesehen, deren Normale der Strömungsrichtung entspricht, die der Kühlkanal (aufgrund seiner Verbindung mit Anschlüssen) vorgibt. Die Normalen der Querschnitte der beiden Abschnitte sind im Wesentlichen senkrecht zueinander.

Der Längsabschnitt weist (in Längsrichtung der elektrischen Maschine betrachtet) einen ersten Unterabschnitt auf, der von einem Umfang eines Wicklungskörpers begrenzt ist. Dieser Wicklungskörper umfasst den Stator. Der Längsabschnitt weist ferner (in Längsrichtung der elektrischen Maschine betrachtet) einen zweiten Unterabschnitt auf, der von einem Umfang eines Wicklungskopfs des Stators begrenzt ist. Der Umfang des Wicklungskörpers und der Umfang eines Wicklungskopfs bilden für den ersten und den zweiten Unterabschnitt eine Begrenzung zur Längsachse der elektrischen Maschine hin. Beide Unterabschnitte sind von dem Gehäuse nach außen begrenzt, insbesondere von einer Innenseite des Gehäuses. Der erste Unterabschnitt und der zweite Unterabschnitt sind miteinander verbunden und gehen vorzugsweise (unmittelbar) ineinander über. Der zweite Unterabschnitt ist mit dem Stirnseitenabschnitt verbunden, vorzugsweise unmittelbar.

Die beiden Abschnitte gehen vorzugsweise unmittelbar oder über eine Verbindungselement wie eine Öffnung in einer stirnseitig verlaufenden Wand ineinander über. Der erste Unterabschnitt ist über den zweiten Unterabschnitt mit dem Stirnseitenabschnitt verbunden. Ein Wärmemediumzulauf oder ein Wärmemediumablauf kann an einem Ende des ersten Unterabschnitts vorgesehen sein, das dem Ende ersten Unterabschnitts entgegengesetzt ist, welches an den zweiten Unterabschnitt angeschlossen ist. Der Stirnseitenabschnitt ist von einer Stirnseite des Wicklungskopfs begrenzt. Die Stirnseite kann in einer Ebene liegen, in der ferner ein Übergang oder eine Verbindung zwischen dem Längsabschnitt und dem Stirnseitenabschnitt angeordnet ist. Der Übergang bzw. die Verbindung liegen in einer von der Welle weg weisenden Fortsetzung bzw. Verlängerung der Stirnseite.

Die elektrische Maschine weist ferner ein Lagerschild auf. Dieses ist mit einer Innenseite ausgestattet, die die Leistungselektronik trägt. Es können in dem Lagerschild Ausnehmungen vorgesehen sein, in der die Leistungselektronik angeordnet ist. Die Ausnehmungen sind auf einer Seite des Lagerschilds, die zum Stator bzw. zum Wickelkopf weist. Ein weiterer Lagerschild kann an dem entgegengesetzten Ende der elektrischen Maschine vorgesehen sein, insbesondere an einem Ende des Längsabschnitts, das dem mit dem Stirnseitenabschnitt des Kühlkanals verbundenen Ende des Längsabschnitts entgegengesetzt ist. Die Welle wird von einem Lager des Lagerschilds (welches die Leistungselektronik trägt) drehbar gelagert. Ferner durchstößt die Welle das Lageschild, welches die Leistungselektronik trägt. Die Leistungselektronik oder Teile hiervon (etwa die Leistungstransistoren) kann bzw. können in umfänglich verteilten Segmenten des Lagerschilds vorgesehen sein. Insbesondere können 3, 6, 9, (oder ein weiteres Vielfaches von drei) Segmente vorgesehen sein. Diese sind insbesondere gleich aufgebaut und an unterschiedlichen Segmenten (zu einander winkelversetzt) des Lagerschilds angeordnet.

Der Längsabschnitt ist vorzugsweise zumindest durch eine Wand in mindestens zwei Teile aufgeteilt. Dadurch kann der Längsabschnitt einen Hinkanal zum Stirnseitenabschnitt und einen Rückkanal vom Stirnseitenabschnitt bilden. Die Wand kann zumindest abschnittsweise geradlinig verlaufen, wobei jedoch auch ein mäandernder Verlauf vorgesehen sein kann. Die Längserstreckungsrichtung der Wand verläuft auf der Umfangsfläche des Stators bzw. auf einem Mantel, der den umfänglichen Verlauf des Stators bzw. der Innenseite des Gehäuses wiedergibt. Somit erstreckt sich die Wand in einer Richtung, entlang der die Welle verläuft. Ferner erstreckt sich die Wand (in Quererstreckungsrichtung der Wand) von dem Stator zu dem Gehäuse. Die Wand verbindet (fluiddicht) den Stator bzw. den Wicklungskörper mit dem Gehäuse. Die Wand verbindet fluiddicht die Außenseite (der Umfangsfläche) des Stators mit der Innenseite des Gehäuses. Die Wand begrenzt den Kühlkanal innerhalb des Längsabschnitts. Die Wand ist mit anderen Worten ausgestaltet, das Wärmemedium zu führen. Die Wand bildet zusammen mit der Innenseite des Gehäuses und der Außenseite (der Umfangsfläche) des Stator die umfängliche Begrenzung des Längsabschnitts des Kühlkanals.

Ferner weist die elektrische Maschine einen Wärmemediumzulauf und einen Kühlmittelablauf auf. Zwischen diesen erstreckt sich der Kühlkanal. Der Kühlkanal verbindet vorzugsweise den Wärmemediumzulauf mit dem Kühlmittelablauf. Der Wärmemediumzulauf und der Kühlmittelablauf können an der gleichen Stirnseite des Gehäuses angeordnet sein, insbesondere an einer Stirnseite, die entgegengesetzt ist zu derjenigen Stirnseite, an welcher der Stirnseitenabschnitt vorgesehen ist. Der Wärmemediumzulauf und der Kühlmittelablauf können an entgegengesetzten Enden der elektrischen Maschine oder an dem gleichen Ende der elektrischen Maschine vorgesehen sein (in Längsrichtung der elektrischen Maschine gesehen). Vorzugsweise sind der Wärmemediumzulauf und der Kühlmittelablauf an entgegengesetzten Stirnseiten (insbesondere an entgegengesetzten Lagerschilden) der elektrischen Maschine angeordnet, oder, alternativ, oder an der gleichen Stirnseite (insbesondere am gleichen Lagerschild) angeordnet.

Der Wärmemediumzulauf und der Kühlmittelablauf können durch ein weiteres Lagerschild hindurch verlaufen, das in Bezug auf die elektrische Maschine entgegengesetzt zu einem Lagerschild ist, welches den Stirnseitenabschnitt begrenzt und insbesondere die Leistungselektronik trägt.

Der Längsabschnitt kann sich entlang mehrerer geschnittener Hohlzylinder erstreckt, die in Längserstreckungsrichtung der Welle in Sektoren unterteilt sind. Die geschnittenen Hohlzylinder und Stirnseiten unterschiedlicher geschnittenen Hohlzylinder sind über den Stirnseitenabschnitt miteinander verbunden sind. Dadurch bilden unterschiedliche, geschnittene Hohlzylinder einen Hinkanal und einen Rückkanal. Die geschnittenen Hohlzylinder ergeben sich insbesondere durch eine Wand, die sich von einer Außenseite des Stators zu einer Innenseite des Gehäuses erstreckt. Diese Wand kann sich einer oder in mehreren Ebenen erstrecken, in der die Welle bzw. die Längsachse der elektrischen Maschine liegt.

### Kurzbeschreibung der Zeichnungen

Die Figur 1 zeigt einen Querschnitt durch eine beispielhafte Ausführungsform einer hier beschriebenen elektrischen Maschine.
Die Figur 2 zeigt eine Draufsicht auf eine beispielhafte Ausführungsform einer hier beschriebenen elektrischen Maschine.

### Detaillierte Beschreibung der Zeichnung

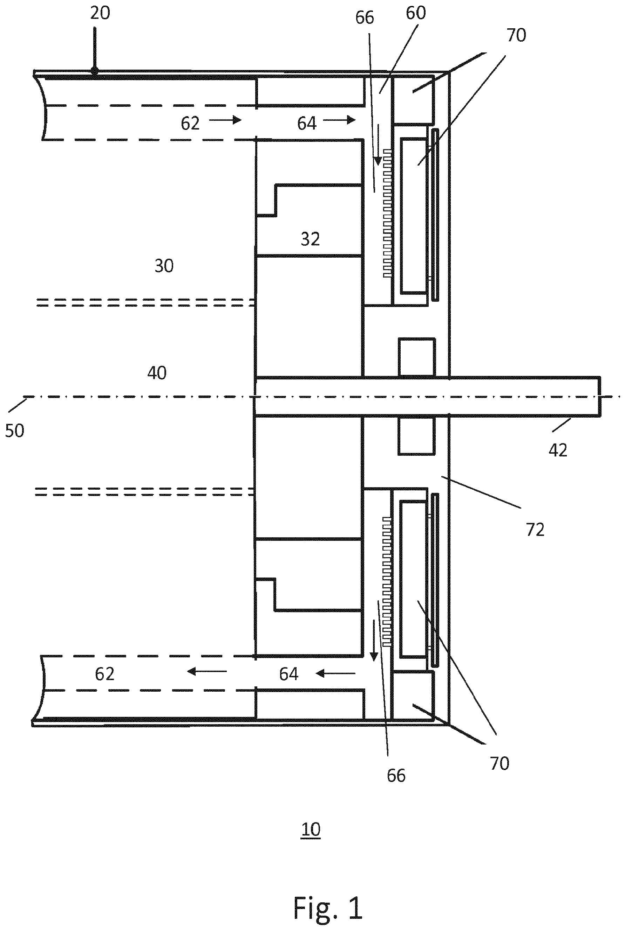

Die Figur 1 zeigt einen Querschnitt durch eine beispielhafte Ausführungsform einer hier beschriebenen elektrischen Maschine 10 mit einem Gehäuse 20 sowie mit einem Stator 30, 32 und einem Rotor 40, 42.

Der in Figur 1 dargestellte Querschnitt verläuft längs durch die elektrische Maschine hindurch, insbesondere durch die Welle bzw. Rotationsachse 50 der elektrischen Maschine hindurch. Die Figur 1 zeigt nur einen Teil der elektrischen Maschine, der eine Stirnseite bzw. ein Lagerschild der elektrischen Maschine umfasst.

Der Rotor ist mit einer Welle 42 ausgestattet, welcher eine Rotationsachse 50 aufweist. Ferner ist in der elektrischen Maschine 10 Leistungselektronik 70 vorgesehen. Diese erstreckt sich entlang der in Figur 1 senkrecht verlaufenden Stirnseite. Die Leistungselektronik umfasst Leistungskondensatoren (mit dem obersten und dem untersten Rechteck 70 dargestellt), sowie Leistungsansteuerstufen welche mit den beiden Rechtecken 70 dargestellt sind, die zwischen dem obersten und untersten Rechteck liegen.

Die Leistungsendstufen weisen eine Kühlfläche mit Kühlfingern oder ähnlichen Strukturen zur Erhöhung der Oberfläche auf, die in dem Stirnseitenabschnitt 66 des Kühlkanals hineinragen bzw. an die der Kühlkanal angrenzt. Ein Lagerschild 72 schließt das Gehäuse 20 an der in Figur 1 dargestellten Stirnseite ab und dient ferner dazu, mittels eines Wälzlagers die Welle 42 drehbar zu lagern.

Der Stator umfasst einen Wickelkörper 30 und einen sich daran anschließenden Wickelkopf 32. Der Längsabschnitt 62, 64 kann unterteilt werden in einen ersten Unterabschnitt 62 der sich entlang der Längserstreckung (bezogen auf die Achse 50) des Stators und somit entlang des Wickelkörpers 30 erstreckt, während ein zweiter Unterabschnitt 64 sich entlang der Umfangsfläche des Wickelkopfs 32 erstreckt. Der zweite Unterabschnitt 64 schließt sich an den ersten Unterabschnitt 62 des Längsabschnitts an.

Der zweite Unterabschnitt 64 (und somit der Längsabschnitt) geht an dem Ende des Wickelkopfs 32, welches von dem Wickelkörper 30 abgewandt ist, in den Stirnseitenabschnitt 66 über.

Die Figur 1 zeigt, dass von einem Teil des ersten Unterabschnitts 62, der in Figur 1 oben dargestellt ist, das Wärmemedium ausgehend von diesem (Teil des) ersten Unterabschnitts 62 in einen Teil des zweiten Unterabschnitts 64 übergeht. Mit dem Ende des Längsabschnitts beziehungsweise des zweiten Unterabschnitts ändert sich die Flussrichtung (im Wesentlichen um einen Winkel von 90°) .

Wie in Figur 1 dargestellt ist, fließt das Kühlmedium nach dem Längsabschnitt nicht mehr entlang der Richtung, in der sich die Welle 42 erstreckt, sondern fließt zur Welle hin beziehungsweise fließt vor/beim Erreichen der Welle um diese herum, um, wie in der unteren Bildhälfte dargestellt, zu einem zweiten Teil des Längsabschnitts zu gelangen, der in der unteren Bildhälfte dargestellt ist und das Bezugszeichen 64 trägt. Mit dem unteren Teil des Längsabschnitts wird das Wärmemedium von dem Stirnseitenabschnitt 66 des Kühlkanals wegtransportiert, zunächst über einen (Teil des) zweiten Abschnitt 64 und dann über einen (Teil des) ersten Abschnitt 62, welcher wiederum zu einem Wärmemediumablauf führt. Die Strömungsrichtung im Stirnseitenabschnitt 66 führt daher zum einen zur Welle hin, sowie zur Welle weg und führt insbesondere in der Nähe der Welle, dass heißt kurz vor Erreichen des Abschnitts des Lagerschilds 72, der die Welle lagert, um die Welle beziehungsweise um den Abschnitt, der diese lagert herum. Die Strömungsrichtung im Stirnseitenabschnitt 66 ist somit im Wesentlichen senkrecht zu der Strömungsrichtung in dem Längsabschnitt 62, 64.

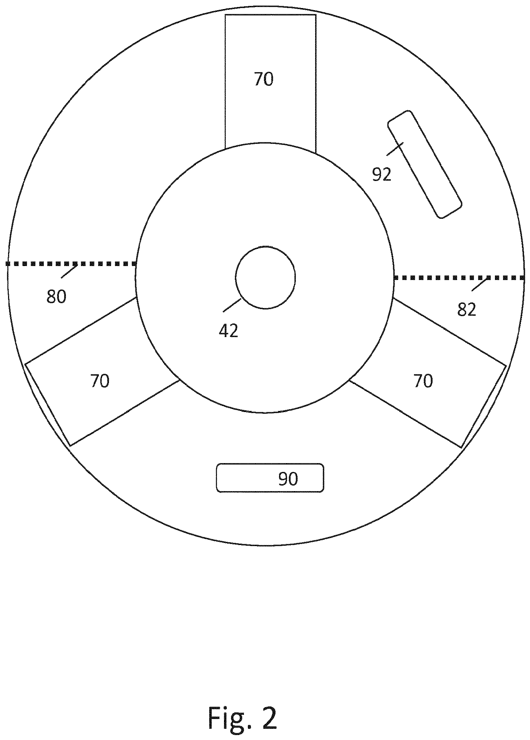

Die Strömungsrichtung in dem unteren Teil des Längsabschnitts 62, 64 ist entgegengesetzt zur Strömungsrichtung im oberen Teil des Längsabschnitts 62, 64, wobei eine Wand 80 (in Figur 2 dargestellt) dem Längsabschnitt in zwei Teile aufteilt. Einer dieser Teile des Längsabschnitts führt das Medium (von einem Wärmemediumzulauf) zu dem stirnseitigen Abschnitt 66 hin, wobei der andere Teil des Längsabschnitts, in Figur 1 unten dargestellt, das Wärmemedium von dem Stirnseitenabschnitt 66 wegführt (und zu einem Wärmemediumablauf leitet).

In Figur 1 ist die in der oberen Bildhälfte dargestellte Leistungselektronik 70, die in der unteren Bildhälfte der Figur 1 dargestellt ist. Dies ist jedoch eine vereinfachte Darstellung, wobei die Leistungselektronik nicht notwendigerweise auf Segmente verteilt ist, von denen sich zwei bezogen auf die Längsachse 50 exakt gegenüberstehen (d.h. um 180° zueinander versetzt sind). Stattdessen kann die Leistungselektronik auch auf andere Weise verteilt sein, wie es etwa in Figur 2 dargestellt ist.
Die Figur 2 zeigt eine Draufsicht auf eine beispielhafte Ausführungsform einer hier beschriebenen elektrischen Maschine. Hierbei ist die Leistungselektronik 70 auf drei Abschnitte (die hier auch als Segmente bezeichnet werden) verteilt, die zueinander um 120 Grad (in Umfangsrichtung des Stators) verteilt sind.

Während sich die Leistungselektronik 70 an einem Lagerschild beziehungsweise an einer Stirnseite der elektrischen Maschine befindet, die der in Figur 1 dargestellten Stirnseite beziehungsweise dem Lagerschild 72 entgegengesetzt ist, befinden sich ein Wärmemediumzulauf 90 und ein Wärmemediumablauf 92 an der hierzu entgegengesetzten Stirnseite. Der Wärmemediumzulauf 90 und der Wärmemediumablauf 92 sind innerhalb eines Lagerschilds vorgesehen, das entgegengesetzt zu dem in Figur 1 dargestellten Lagerschilds positioniert ist.

Eine Wand 80, 82 erstreckt sich über zwei Abschnitte und unterteilt, wie in Figur 2 schematisch dargestellt ist, den hohlzylindrischen Raum zwischen Stator und Gehäuse, so dass zwei (im Allgemeinen mehrere) geschnittene Hohlzylinder entstehen. Während ein geschnittener Hohlzylinder an dem Wärmemediumzulauf vorgesehen ist, ist ein anderer geschnittener Hohlzylinder an dem Wärmemediumablauf angeschlossen. Dadurch ergibt sich wie in der Figur 1 in der Figur 2 in der oberen Bildhälfte eine erste Kühlmittelrichtung entlang der Umfangsfläche des Stators, die der Kühlmittelrichtung in der unteren Bildhälfte entgegengesetzt ist.

In der Figur 2 ist dargestellt, dass die Wand 80, 82 in einen ersten Längsabschnitt 80 und einen zweiten Längsabschnitt 82 unterteilbar ist. Diese Längsabschnitte 80, 82 verlaufen im Wesentlichen in einer Ebene, durch die hindurch auch die Welle 42 erstreckt. Jedoch ist dies nicht unbedingt notwendig, so dass die Längsabschnitte 80, 82 an im Querschnitt entgegengesetzten Seiten der elektrischen Maschine vorgesehen sein können, jedoch nicht notwendiger Weise um 180 Grad in Umfangsrichtung des Stators zueinander versetzt sein müssen.
Bei der in Figur 2 dargestellten Aufteilung in zwei (oder mehr als zwei) gleich große geschnittene Hohlzylinder ergibt sich der Vorteil, der Abschnitt des Kühlkanals zum Stirnflächenabschnitt hin die gleiche Querschnittfläche hat wie der Abschnitt des Kühlkanals, der von dem Stirnseitenabschnitt weg führt.

Alternativ zu der in Figur 2 dargestellten Ausführungsform können auch mehrere Wärmemediumzuläufe und/oder mehrere Wärmemediumabläufe vorgesehen sein, wobei die Zu- oder Abläufe jeweils von einer Wand - wie in Figur 2 als Punktlinie dargestellt - getrennt werden.

### Bezugszeichenliste

- 10: elektrische Maschine
- 20: Gehäuse
- 30: Wickelkörper des Stators
- 32: Wickelkopf des Stators
- 30+32: Stator
- 40: Rotor
- 42: Welle des Rotors
- 50: Rotationsachse des Rotors beziehungsweise Längserstreckungsrichtung der elektrischen Maschine 10
- 60: Kühlkanal
- 62, 64: Längsabschnitt des Kühlkanals, der in einen ersten Unterabschnitt 62 und einen zweiten Unterabschnitt 64 des Längsabschnitts unterteilt ist
- 70: Leistungselektronik (Leistungsansteuerstufe mit Leistungshalbleitern sowie ggf. weitere Leistungsbauelemente wie Leistungskondensatoren)
- 80, 82: Wandabschnitte einer Wand, die sich vom Stator bis zur Innenseite des Gehäuses erstreckt
- 90: Wärmemediumzulauf
- 92: Wärmemediumablauf

## Patentansprüche

1. Elektrische Maschine (10) mit einem Gehäuse (20), einem Stator (30, 32) und einem Rotor (40, 42), wobei der Stator (30, 32) den Rotor (40, 42) umgreift, der Rotor (40, 42) eine Welle (42) aufweist, und die elektrische Maschine (10) mit einer Leistungselektronik (40) innerhalb des Gehäuses (20) ausgestattet ist, wobei die elektrische Maschine (10) einen Kühlkanal (62, 64, 66) aufweist, der sich entlang eines Längsabschnitts (62, 64) und eines Stirnseitenabschnitts (66) erstreckt, wobei sich der Längsabschnitt (62, 64) entlang eines Hohlzylinders erstreckt, durch dessen Inneres hindurch die Rotationsachse (50) der Welle (42) führt, und sich der Stirnseitenabschnitt (66) zur Welle (42) hin erstreckt, wobei der Längsabschnitt (62, 64) begrenzt ist durch eine Umfangsfläche des Stators (30, 32) einerseits und einer Wand des Gehäuses (20) andererseits, und wobei der Stirnseitenabschnitt (66) begrenzt ist durch eine Stirnseite des Stators einerseits und der Leistungselektronik (70) andererseits, wobei der Längsabschnitt einen ersten Unterabschnitt (62) umfasst, der von einem Umfang eines Wicklungskörpers (30) begrenzt wird, und einen zweiten Unterabschnitt (64) umfasst, der von einem Umfang eines Wicklungskopfs (32) des Stators begrenzt ist, wobei der erste Unterabschnitt (62) über den zweiten Unterabschnitt (64) mit dem Stirnseitenabschnitt (66) verbunden ist, und der Stirnseitenabschnitt (66) von einer Stirnseite des Wicklungskopfs (32) begrenzt ist.

2. Elektrische Maschine (10) nach Anspruch 1, wobei sich die Leistungselektronik (40) entlang einer Ringfläche erstreckt, durch deren Mitte hindurch die Welle (42) stößt, wobei die Leistungselektronik (40) eine Kühlfläche aufweist, die den Stirnseitenabschnitt (66) begrenzt.

3. Elektrische Maschine (10) nach einem der vorangehenden Ansprüche, wobei der Längsabschnitt (62, 64) unmittelbar in den Stirnseitenabschnitt (66) übergeht, der Querschnitt des Längsabschnitts (62, 64) sich zwischen dem Stator (32, 32) und dem Gehäuse (20) erstreckt, und der Querschnitt des Stirnseitenabschnitts (66) sich zwischen dem Stator (30, 32) und der Leistungselektronik (70) erstreckt.

4. Elektrische Maschine (10) nach einem der vorangehenden Ansprüche, die ferner ein Lagerschild (72) aufweist, welches eine Innenseite aufweist, die die Leistungselektronik (70) trägt, wobei die Welle (42) mittels eines Lagers des Lagerschilds (72) drehbar gelagert ist und die Welle (42) das Lageschild (72) durchstößt.

5. Elektrische Maschine (10) nach einem der vorangehenden Ansprüche, wobei der Längsabschnitt (62, 64) durch zumindest eine Wand (80, 82) in mindestens zwei Teile geteilt ist, wobei sich die Wand (80, 82) zum Einen von dem Stator (30, 32) zu dem Gehäuse (20) erstreckt sowie zum Anderen in einer Richtung erstreckt, entlang der die Welle (42) verläuft.

6. Elektrische Maschine (10) nach einem der vorangehenden Ansprüche, die ferner einen Wärmemediumzulauf (92) und einen Wärmemediumablauf (90) aufweist, zwischen denen sich der Kühlkanal (60) erstreckt, wobei der Wärmemediumzulauf (92) und der Wärmemediumablauf (90) an der gleichen Stirnseite des Gehäuses (20) angeordnet sind, insbesondere an einer Stirnseite, die entgegengesetzt ist zu derjenigen Stirnseite, an welcher der Stirnseitenabschnitt (66) vorgesehen ist.

7. Elektrische Maschine (10) nach Anspruch 6, wobei der Wärmemediumzulauf (92) und der Wärmemediumablauf (90) durch ein weiteres Lagerschild (72) hindurch verlaufen, das in Bezug auf die elektrische Maschine (10) entgegengesetzt zu einem Lagerschild ist, welches den Stirnseitenabschnitt (66) begrenzt und insbesondere die Leistungselektronik (70) trägt.

8. Elektrische Maschine (10) nach einem der vorangehenden Ansprüchen, wobei der Längsabschnitt (62, 64) sich entlang mehrerer geschnittener Hohlzylinder erstreckt, die in Längserstreckungsrichtung der Welle (42) in Sektoren unterteilt sind, wobei die geschnittenen Hohlzylinder und Stirnseiten unterschiedlicher Hohlzylinder über den Stirnseitenabschnitt (66) miteinander verbunden sind.

## Claims

1. Electric machine (10) comprising a housing (20), a stator (30, 32) and a rotor (40, 42), wherein the stator (30, 32) embraces the rotor (40, 42), the rotor (40, 42) has a shaft (42), and the electric machine (10) is equipped with power electronics (40) inside the housing (20), wherein the electric machine (10) has a cooling duct (62, 64, 66) which extends along a longitudinal section (62, 64) and along an end side section (66), wherein the longitudinal section (62, 64) extends along a hollow cylinder, through the interior of which the axis of rotation (50) of the shaft (42) leads, and the end side section (66) extends toward the shaft (42), wherein the longitudinal section (62, 64) is bounded by a circumferential surface of the stator (30, 32) on one side and a wall of the housing (20) on the other side, and wherein the end side section (66) is bounded by an end side of the stator on one side and of the power electronics (70) on the other side, wherein the longitudinal section comprises a first subsection (62) which is bounded by a circumference of a winding body (30), and a second subsection (64) which is bounded by a circumference of a winding head (32) of the stator, wherein the first subsection (62) is connected via the second subsection (64) to the end side section (66), and the end side section (66) is bounded by an end side of the winding head (32).

2. Electric machine (10) according to Claim 1, wherein the power electronics (40) extend along an annular surface, through the center of which the shaft (42) pushes, wherein the power electronics (40) have a cooling surface which bounds the end side section (66).

3. Electric machine (10) according to one of the preceding claims, wherein the longitudinal section (62, 64) merges directly into the end side section (66), the cross section of the longitudinal section (62, 64) extends between the stator (32, 32) and the housing (20), and the cross section of the end side section (66) extends between the stator (30, 32) and the power electronics (70) .

4. Electric machine (10) according to one of the preceding claims, which furthermore has a bearing shield (72) which has an inner side which bears the power electronics (70), wherein the shaft (42) is mounted rotatably by means of a bearing of the bearing shield (72), and the shaft (42) pushes through the bearing shield (72).

5. Electric machine (10) according to one of the preceding claims, wherein the longitudinal section (62, 64) is divided into at least two parts by at least one wall (80, 82), wherein the wall (80, 82) firstly extends from the stator (30, 32) to the housing (20) and secondly extends in a direction along which the shaft (42) runs.

6. Electric machine (10) according to one of the preceding claims, which furthermore has a heat medium inlet (92) and a heat medium outlet (90), between which the cooling duct (60) extends, wherein the heat medium inlet (92) and the heat medium outlet (90) are arranged on the same end side of the housing (20), in particular on an end side which is opposite the end side on which the end side section (66) is provided.

7. Electric machine (10) according to Claim 6, wherein the heat medium inlet (92) and the heat medium outlet (90) run through a further bearing shield (72) which, with respect to the electric machine (10) is opposite a bearing shield which bounds the end side section (66) and in particular bears the power electronics (70) .

8. Electric machine (10) according to one of the preceding claims, wherein the longitudinal section (62, 64) extends along a plurality of cut hollow cylinders which are divided into sectors in the direction of longitudinal extent of the shaft (42), wherein the cut hollow cylinders and end sides of different hollow cylinders are connected to one another via the end side section (66) .

## Revendications

1. Machine électrique (10) comprenant un carter (20), un stator (30, 32) et un rotor (40, 42), le stator (30, 32) entourant le rotor (40, 42), le rotor (40, 42) possédant un arbre (42) et la machine électrique (10) étant équipée d'une électronique de puissance (40) à l'intérieur du carter (20), la machine électrique (10) possédant un canal de refroidissement (62, 64, 66) qui s'étend le long d'une portion longitudinale (62, 64) et d'une portion côté frontal (66), la portion longitudinale (62, 64) s'étendant le long d'un cylindre creux à travers l'intérieur duquel passe l'axe de rotation (50) de l'arbre (42), et la portion côté frontal (66) s'étendant en direction de l'arbre (42), la portion longitudinale (62, 64) étant délimitée par une surface circonférentielle du stator (30, 32) d'un côté et par une paroi du carter (20) de l'autre côté, et la portion côté frontal (66) étant délimitée par un côté frontal du stator d'un côté et par l'électronique de puissance (70) de l'autre côté, la portion longitudinale comportant une première portion inférieure (62) qui est délimitée par un pourtour d'un corps de bobine (30), et comportant une deuxième portion inférieure (64) qui est délimitée par un pourtour d'une tête de bobine (32) du stator, la première portion inférieure (62) étant reliée à la portion côté frontal (66) par le biais de la deuxième portion inférieure (64) et la portion côté frontal (66) étant délimitée par un côté frontal de la tête de bobine (32).

2. Machine électrique (10) selon la revendication 1, l'électronique de puissance (40) s'étendant le long d'une surface annulaire dont le centre est transpercé par l'arbre (42), l'électronique de puissance (40) possédant une surface de refroidissement qui délimite la portion côté frontal (66).

3. Machine électrique (10) selon l'une des revendications précédentes, la portion longitudinale (62, 64) transitant directement dans la portion côté frontal (66), la section transversale de la portion longitudinale (62, 64) s'étendant entre le stator (32, 32) et le carter (20), et la section transversale de la portion côté frontal (66) s'étendant entre le stator (30, 32) et l'électronique de puissance (70).

4. Machine électrique (10) selon l'une des revendications précédentes, laquelle possède en outre un flasque (72), lequel possède un côté intérieur qui porte l'électronique de puissance (70), l'arbre (42) étant monté à rotation au moyen d'un palier du flasque (72) et l'arbre (42) transperçant le flasque (72).

5. Machine électrique (10) selon l'une des revendications précédentes, la portion longitudinale (62, 64) étant divisée en au moins deux parties par au moins une paroi (80, 82), la paroi (80, 82) s'étendant d'une part du stator (30, 32) vers le carter (20) ainsi que d'autre part dans une direction le long de laquelle chemine l'arbre (42).

6. Machine électrique (10) selon l'une des revendications précédentes, laquelle possède en outre une arrivée de fluide calorifique (92) et une évacuation de fluide calorifique (90), entre lesquelles s'étend le canal de refroidissement (60), l'arrivée de fluide calorifique (92) et l'évacuation de fluide calorifique (90) étant disposées sur le même côté frontal du carter (20), notamment sur un côté frontal qui est situé à l'opposé du côté frontal sur lequel se trouve la portion côté frontal (66).

7. Machine électrique (10) selon la revendication 6, l'arrivée de fluide calorifique (92) et l'évacuation de fluide calorifique (90) passant à travers un flasque (72) supplémentaire qui, en référence à la machine électrique (10), est à l'opposé d'un flasque qui délimite la portion côté frontal (66) et notamment qui porte l'électronique de puissance (70).

8. Machine électrique (10) selon l'une des revendications précédentes, la portion longitudinale (62, 64) s'étendant le long de plusieurs cylindres creux coupés qui, dans le sens de l'extension longitudinale de l'arbre (42), sont divisés en secteurs, les cylindres creux coupés et les côtés frontaux des différents cylindres creux étant reliés entre eux par le biais de la portion côté frontal (66).
